(19) Europäisches Patentamt

European Patent Office

Office européen des brevets

(11) **EP 3 252 907 B1**

(12) **EUROPEAN PATENT SPECIFICATION**

(45) Date of publication and mention
of the grant of the patent:
**18.12.2019 Bulletin 2019/51**

(21) Application number: **16743009.9**

(22) Date of filing: **28.01.2016**

(51) Int Cl.:
*H02J 3/26* *(2006.01)*     *G01R 29/18* *(2006.01)*

(86) International application number:
**PCT/JP2016/000451**

(87) International publication number:
**WO 2016/121405 (04.08.2016 Gazette 2016/31)**

(54) **POWER CONTROL DEVICE AND METHOD FOR CONTROLLING SAME**

ENERGIESTEUERUNGSVORRICHTUNG UND VERFAHREN ZUR STEUERUNG DAVON

DISPOSITIF DE COMMANDE DE PUISSANCE ET PROCÉDÉ DE COMMANDE CORRESPONDANT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.01.2015   JP 2015015714**

(43) Date of publication of application:
**06.12.2017   Bulletin 2017/49**

(73) Proprietor: **Kyocera Corporation
Kyoto-shi, Kyoto 612-8501 (JP)**

(72) Inventor: **SHICHIRI, Kazumasa
Kyoto-shi
Kyoto 612-8501 (JP)**

(74) Representative: **SSM Sandmair
Patentanwälte Rechtsanwalt
Partnerschaft mbB
Joseph-Wild-Straße 20
81829 München (DE)**

(56) References cited:
**EP-A2- 1 457 785       WO-A1-2013/061475
WO-A1-2014/125590   JP-A- 2002 168 883
JP-A- 2002 286 769   JP-A- 2011 021 986**

## Description

CROSS REFERENCE TO RELATED APPLICATION

TECHNICAL FIELD

This disclosure relates to a power control apparatus and a control method for the same.

BACKGROUND

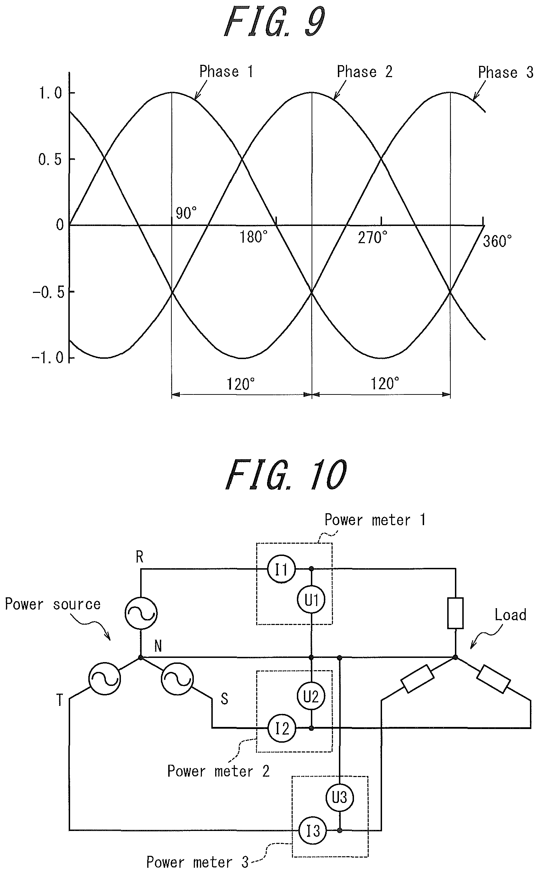

Some industrial machinery, for example, use a three-phase AC power source. As illustrated in FIG. 9, the three-phase AC power source has voltage waveforms in which phases have phase differences of 120 degrees from their adjacent phases. The three-phase AC power source also has current waveforms in which, similarly to the voltage waveform, phases have the phase differences of 120 degrees from their adjacent phases.

A phase difference between the current waveform and the voltage waveform depends on a coupled load. When the load is a simple resistive load or an electronic circuit having a power factor of 1, the current waveform and the voltage waveform are in phase with each other. When the load has a capacitive component (a C-component), a phase of the current waveform advances relative to a phase of the voltage waveform, and when the load has an inductance component (an L-component), the phase of the current waveform is delayed relative to the phase of the voltage waveform.

Theoretically, the phase of the current waveform may have a phase difference in a range of -90 to +90 degrees relative to the phase of the voltage waveform. Usually, however, due to the power factor of the load being designed to fall within a range of 0.85 to 1, the phase of the current waveform does not shift as far as -90 degrees or +90 degrees relative to the phase of the voltage waveform.

FIG. 10 illustrates a state in which a power source supplies power to a load according to a three-phase four-wire distribution system. In this example, power of an R-phase, power of an S-phase, and power of a T-phase are measured by a power meter 1, a power meter 2, and a power meter 3, respectively. Note that an N-phase in FIG. 10 represents a neutral line.

In the example illustrated in FIG. 10, a total power P may be calculated from the following equation:

$$P = U1 \times I1 + U2 \times I2 + U3 \times I3,$$

where U1, U2, and U3 represent a voltage on the R-phase, a voltage on the S-phase, and a voltage on the T-phase, respectively; and I1, I2, and I3 represent a current on the R-phase, a current on the S-phase, and a current on the T-phase, respectively. For example, patent literature PLT 1 set forth below describes a method of autonomously correcting an installation direction of a current sensor for a personal power-generation system having a single-phase three-wire distribution system. As such, there is a demand for a method of correcting an installation direction of the current sensor for a power source having the three-phase four-wire distribution system.

CITATION LIST

Patent Literature

PLT 1: JP-A-2004-297959
JP 2002 168883 A provides a displaying method for a vector line that can visually confirm presence of a wrong connection to a measured electric line in a three-phase four-wire system with easiness.
EP 1 457 785 A2 relates to a three-phase monitoring system for detecting and dynamically correcting wiring errors in an electrical circuit.
WO 2014/125590 A1 provides a determining device, a determining method, and a program capable of determining misplacement if a current transformer is misplaced on a power line.

SUMMARY

(Solution to Problem)

A power control apparatus according to an embodiment of the disclosure acquires three-phase current values from a first current sensor, a second current sensor, and a third current sensor that are provided to a three-phase AC power source having a first phase, a second phase and a third phase. The power control apparatus includes a current measurement unit for acquiring the three-phase current values of the three-phase AC power source from the first current sensor, the second current sensor and the third current sensor. The power control apparatus also includes a controller for comparing phase differences between the three-phase current values and performing a current value sign correction operation to invert a sign of a current value of one of the three phase current values having a phase difference, from each of the other two phases, equal to or smaller than a predetermined phase difference.

A control method for a power control apparatus according to an embodiment of the disclosure includes acquiring three-phase current values from a first current sensor, a second current sensor, and a third current sensor that are provided to a three-phase AC power source having a first phase, a second phase and a third phase. In particular, the control method of the power control apparatus includes a step of acquiring the three-phase current values of the three-phase AC power source from the first current sensor, the second current sensor and the third current sensor, and a step of comparing phase differences between the three-phase current values and performing a current value sign correction operation to invert a sign of a current value of one of the three phase current values having a phase difference, from each of the other two phases, equal to or smaller than a predetermined phase difference.

BRIEF DESCRIPTION OF THE DRAWINGS

In the accompanying drawings:

FIG. 1 is a schematic diagram of a power control system that includes a power control apparatus according to one embodiment;
FIGS. 2A and 2B are diagrams of a current value sign correction operation to invert a sign of a current value;
FIGS. 3A and 3B are diagrams of a voltage value sign correction operation to invert a sign of a voltage value;
FIG. 4 is a diagram of an example of an operation to determine correspondence between voltage values and current values;
FIGS. 5A and 5B are diagrams of another example of the operation to determine correspondence between the voltage values and the current values;
FIG. 6 is a diagram of an example in which correspondence between the voltage values and the current values cannot be determined;
FIG. 7 is a flowchart of an operation of the power control apparatus according to one embodiment;
FIG. 8 is a diagram of a schematic configuration of a power control system having a three-phase three-wire distribution system;
FIG. 9 is a graph of a voltage waveform of a typical three-phase AC power source; and
FIG. 10 is a diagram of power measurement in a three-phase four-wire distribution system.

DETAILED DESCRIPTION

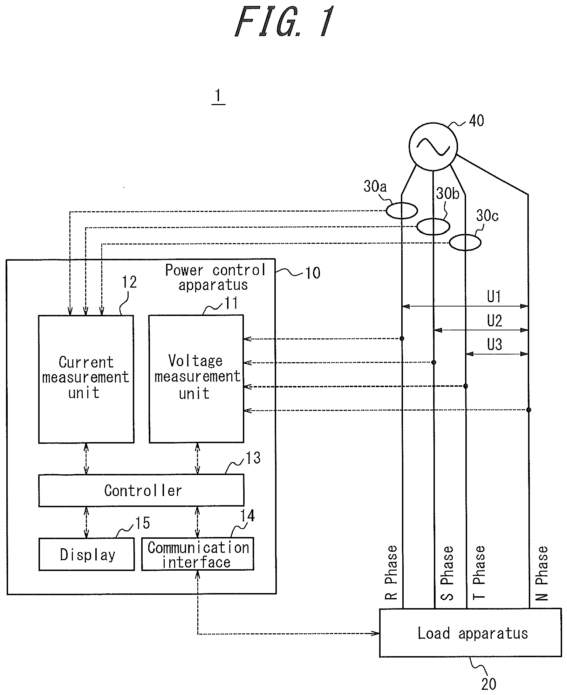

Hereinafter, an embodiment will be described with reference to the drawings.
A power control system 1, as illustrated in FIG. 1, includes a power control apparatus 10, a load apparatus 20, and current sensors 30a to 30c. In FIG. 1, a solid line connecting functional blocks together represents a power line, and a broken line indicates a communication line or a signal line. A connection represented by the communication line or the signal line may be either a wired connection or a radio connection.
In the power control system 1, a power grid 40 supplies power to the load apparatus 20 through a three-phase four-wire distribution system. The three-phase four-wire distribution system includes an R-phase, an S-phase, a T-phase, and an N-phase. The R-phase, the S-phase, and the T-phase each have voltage phase differences and current phase differences 120 degrees from adjacent phases. The N-phase is a neutral line. The R-phase, the S-phase, and the T-phase may be referred to as a first phase, a second phase, and a third phase, respectively.
The power control apparatus 10 acquires current values of the R-phase, the S-phase, and the T-phase from the current sensors 30a, 30b, and 30c, respectively.
The power control apparatus 10 also acquires voltage values of the R-phase, the S-phase, and the T-phase from voltage detection wires running to the power control apparatus 10 from the R-phase, the S-phase, the T-phase, and the N-phase, respectively. As illustrated in FIG. 1, U1 represents a voltage between the R-phase and the N-phase, U2 represents a voltage between the S-phase and the N-phase, and U3 represents a voltage between the T-phase and the N-phase.
The power control apparatus 10 performs a current value sign correction operation in respect of the acquired current values for the three phases, such that the phase difference between adjacent phases is 120 degrees. The power control apparatus 10 also performs a voltage value sign correction operation in respect of the acquired voltage values for the three phases, such that the phase difference between adjacent phases is 120 degrees. Then, the power control apparatus 10 performs an operation to determine correspondence between the three-phase current values and the three-phase voltage values. Here, correspondence between a current value of one of the three phases and a voltage value of one of the three phases means that these values are measured in the same phase. For example, the current value measured in the R-phase corresponds to the voltage value measured in the R-phase.
The current value sign correction operation, the voltage value sign correction operation, and the operation to determine correspondence between the current values and the voltage values will be described in detail later.
After a determination on the correspondence between all of the acquired current values of the three phases and the acquired voltage values of the three phases has been completed, the power control apparatus 10 can calculate power supplied from the power grid 40 to the load apparatus 20 based on the correspondence.
The power control apparatus 10 is coupled to the load apparatus 20 via the communication line and thus is capable of controlling an operation of the load apparatus 20. Also, the power control apparatus 10 may acquire, via the communication line, information on an operation state of the load apparatus 20.
The load apparatus 20 operates on the power supplied from a three-phase AC power source. The load apparatus 20 may be, for example, an industrial machine.
The current sensors 30a, 30b, and 30c are provided to the R-phase, the S-phase and the T-phase, respectively, and transmit the current values of the R-phase, the S-phase and the T-phase to the power control apparatus 10.
When installing the current sensors 30a, 30b, and 30c to the R-phase, the S-phase, and the T-phase, an operator can perform installation without considering correspondence between the current sensors and these phases or the directions of these current sensors. This is because the power control apparatus 10 autonomously inverts, as necessary, a sign of a current value acquired from a current sensor and also autonomously determines the correspondence between the current values and the voltage values.

Similarly, when connecting the wires for measuring the voltages of the R-phase, the S-phase, and the T-phase, the operator can do so without considering correspondences between the wires and terminals of the power control apparatus 10. This is because the power control apparatus 10 autonomously inverts, as necessary, a sign of a voltage value acquired from the R-phase, the S-phase, or the T-phase and also autonomously determines the correspondence between the current values and the voltage values.

Now, configuration and functioning of the power control apparatus 10 will be described. The power control apparatus 10 includes a voltage measurement unit 11, a current measurement unit 12, a controller 13, a communication interface 14, and a display 15.

The voltage measurement unit 11 acquires voltage values of the R-phase, the S-phase, and the T-phase from the four wires running from the R-phase, the S-phase, the T-phase, and the N-phase. Here, these three voltage values acquired by the voltage measurement unit 11 are referred to as U1, U2, and U3. When the voltage measurement unit 11 acquires U1 to U3, their correspondence to the phases is not known, and values of U1 to U3 may have inverse polarities.

The current measurement unit 12 acquires the current values of the R-phase, the S-phase, and the T-phase from the current sensors 30a to 30c. Here, these three current values acquired by the current measurement unit 12 are referred to as CT1, CT2, and CT3. When the current measurement unit 12 acquires CT1 to CT3, their correspondence to the phases is not known, and values of CT1 to CT3 may have inverse polarities.

The controller 13 controls and manages the power control apparatus 10 in its entirety and may be configured, for example, as a processor.

The controller 13 performs the current value sign correction operation, the voltage value sign correction operation, and the operation to determine correspondence between the current values and the voltage values.

The communication interface 14, upon receiving an instruction from the controller 13, transmits an operation instruction to the load apparatus 20 via the communication line to control the operation of the load apparatus 20. Also, the communication interface 14 receives a state of the load apparatus 20 from the load apparatus 20 via the communication line. For a communication with the load apparatus 20, the communication interface 14 may employ a communication protocol such as, but not limited to, ECHONET Lite® (ECHONET Lite is a registered trademark in Japan, other countries, or both).

The display 15 displays various states of the power control apparatus 10. For example, when the controller 13 cannot determine the correspondence between the voltage values and the current values, the display 15 displays a warning to that effect.

Current Value Sign Correction Operation

The following is a description of the current value sign correction operation performed by the power control apparatus 10.

The controller 13 performs the following operation on the three phase current values CT1 to CT 3 acquired by the current measurement unit 12.

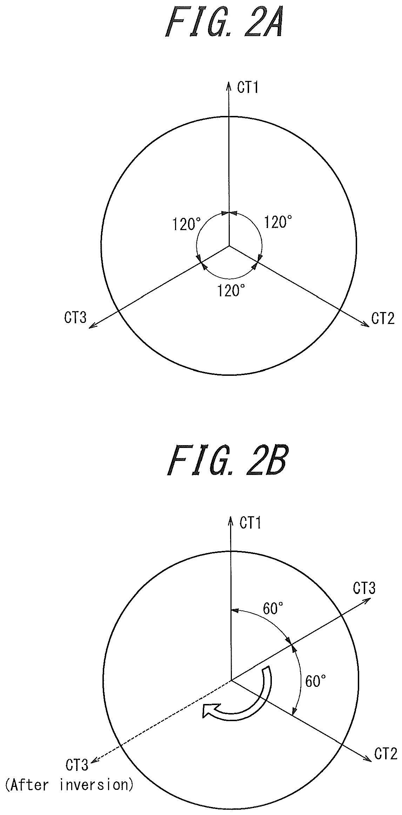

As illustrated in FIG. 2A, when the phase differences between each of CT1, CT2 and CT3 are 120 degrees, the controller 13 determines that the directions of CT1 to CT3 are correct. In this case, the controller 13 fixes the signs of CT1, CT2 and CT3 in this state.

As illustrated in FIG. 2B, when a phase difference of 60 degrees exists between phases, the controller 13 reverses the direction of a current value having a phase difference of 60 degrees from each of the other two phases. In an example of FIG. 2B, because the phase differences of CT3 from the other two phases (the CT1 and the CT2) are each 60 degrees, the controller 13 reverses the direction of CT3. An arrow indicated by a broken line represents the CT3 after its direction is reversed. As illustrated in FIG. 2B, after its direction is reversed, CT3 has a phase difference of 120 degrees from each of CT1 and CT2, and thus the controller 13 fixes the signs of CT1 to CT3 in this state.

Here, the direction is reversed by inverting the sign of the current value by multiplying the current value by -1.

Although in the above description the controller 13 reverses the direction of the current value having the phase difference of 60 degrees from each of the other two phases, the criteria for this decision is not limited thereto. For example, the controller 13 may reverse a direction of a current value having a phase difference of a predetermined threshold (e.g., 65 degrees) or smaller from each of the other two phases. Here, an appropriate situation for setting the predetermined threshold to 65 degrees may be, for example, a case where a load coupled to one of the three phases has a poor balance with other loads coupled to the other two phases and causes a 5 degree phase advance of the one of the three phases.

Voltage Value Sign Correction Operation

Next, the voltage value sign correction operation performed by the power control apparatus 10 will be described.

The controller 13 performs the following operation on the three phase voltage values U1 to U3 acquired by the voltage measurement unit 11.

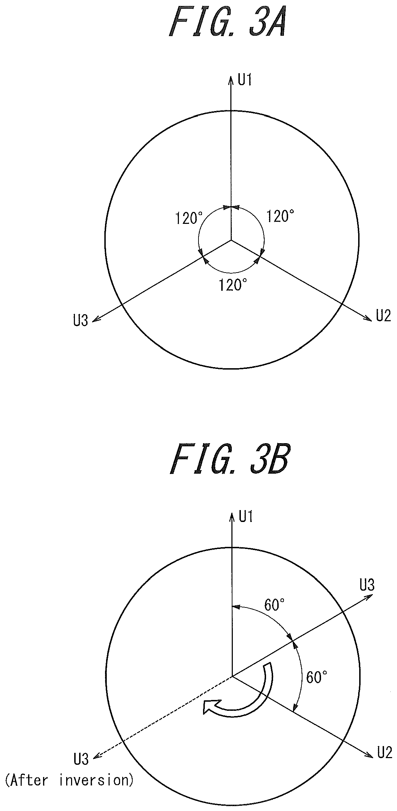

As illustrated in FIG. 3A, when the phase differences between each of U1, U2 and U3 is 120 degrees, the controller 13 determines that the polarities of U1 to U3 are correct. In this case, the controller 13 fixes the signs of U1, U2 and U3 in this state.

As illustrated in FIG. 3B, when a phase differences of 60 degrees exists between phases, the controller 13 inverts the polarity of a voltage value having the phase difference of 60 degrees from each of the other two phases. In an example of FIG. 3B, because the phase differences of U3 from the other two phases (the U1 and the U2) are each 60 degrees, the controller 13 inverts the polarity of U3. An arrow indicated by a broken line represents the U3 after its polarity is inverted. As illustrated in FIG. 3B, after its polarity is inverted, U3 has a phase difference of 120 degrees from each of U1 and U2 and thus the controller 13 fixes the signs of the U1 to the U3 in this state.

Here, the polarity is inverted by inverting the sign of the voltage value by multiplying the voltage value by -1.

Although in the above description the controller 13 inverts the polarity of the voltage value having the phase difference of 60 degrees from each of the other two phases, the criteria for this decision is not limited thereto. For example, the controller 13 may invert a polarity of a voltage value having a phase difference of a predetermined threshold (e.g., 110 degrees) or smaller from each of the other two phases.

Operation to Determine Correspondence between Current Values and Voltage Values

Next, the operation to determine correspondence between the current values and the voltage values will be described.

Theoretically, the phase difference between a current phase and a voltage phase resides in a range of -90 to +90 degrees. In reality, however, this phase difference often resides in a range of -60 to +60 degrees. Also, electrical equipment typically has a delayed phase. Accordingly, with a prescription that the phase difference of the current phase with respect to the voltage phase is a delayed phase of 60 degrees or less, i.e., in a range of 0 to 60 degrees, the operation to determine correspondence between the current values and the voltage values is performed in the following manner.

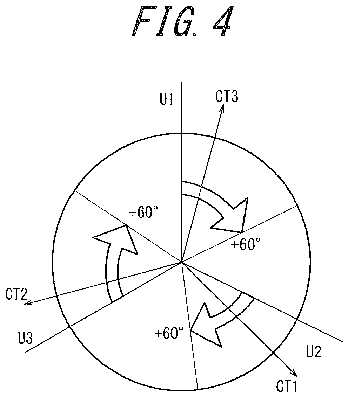

When the three phase current values CT1 to CT3 and the three phase voltage values U1 to U3 are in a phase relation as illustrated in FIG. 4, that is, when the current phases are within the range of 0 to 60 degrees with respect to the voltage phases, the controller 13 determines the correspondence between the current values and the voltage values in this state. For example, in the case of the phase relation illustrated in FIG. 4, the controller 13 determines that CT3 corresponds to U1, CT1 corresponds to U2, and CT2 corresponds to U3.

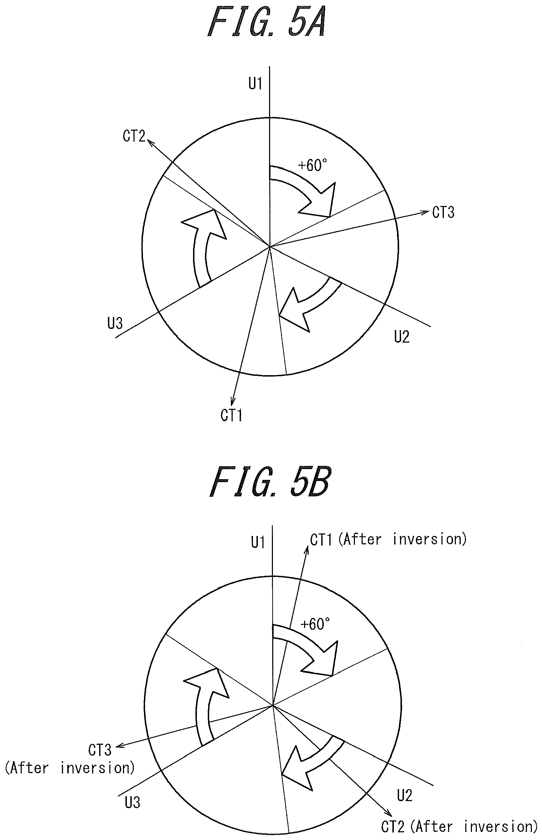

When the three-phase current values CT1 to CT3 and the three-phase voltage values U1 to U3 are in a phase relation as illustrated in FIG. 5A, that is, when the current phase is not within the range of 0 to 60 degrees with respect to the voltage phase, the controller 13 inverts signs of each of CT1 to CT3. FIG. 5B illustrates a state in which the signs of each of CT1 to CT3 have been inverted. The inversion of the signs of CT1 to CT3 results in the phase relation illustrated in FIG. 5B, wherein the current phase is within the range of 0 to 60 degrees with respect to the voltage phase. In this state, the controller 13 determines the correspondence between the current values and the voltage values. For example, in the case of the phase relation illustrated in FIG. 5B, the controller 13 determines that CT1 corresponds to U1, CT2 corresponds to U2, and CT3 corresponds to U3.

Although the above description concerns an example where a delayed phase is prescribed to be within the range of 0 to 60 degrees, in some cases the load apparatus 20 may have properties that cause an advanced phase. In such cases, the advanced phase may be prescribed as being within a range of -60 to 0 degrees. Further, a range of -30 to 30 degrees or a range of -10 to 50 degrees, for example, may be prescribed to make it possible to handle both the advanced phase and the delayed phase.

Displaying a Warning

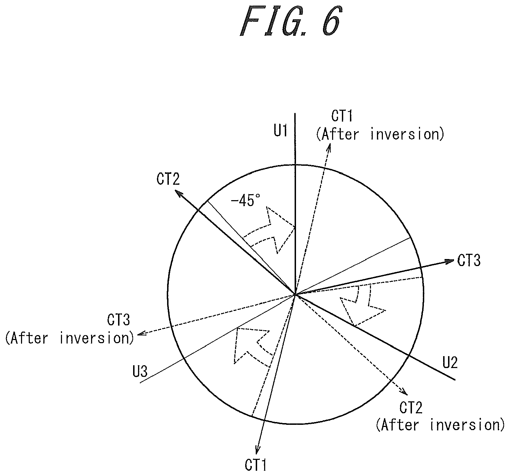

FIG. 6 is a diagram illustrating a case in which the operation to determine correspondence between the voltage values and the current values has been performed, wherein the phase difference of the current phase with respect to the voltage phase is prescribed as an advance phase of 45 degrees or less, i.e., within a range of -45 to 0 degrees.

In an example illustrated in FIG. 6, the three-phase current values CT1 to CT3 are not in the range of -45 to 0 degrees with respect to the three-phase voltage values U1 to U3. Further, after the signs of the CT1 to CT3 have been inverted, CT1 to CT3 after the inversion are still not in the range of -45 to 0 degrees with respect to U1 to U3. In this case, the controller 13 determines that the correspondence between the current values and the voltage values cannot be determined and may cause the display 15 to display a warning to that effect. For example, when the three-phase current values CT1 to CT3 are not in the range of -45 to 0 degrees with respect to the three-phase voltage values U1 to U3, it may be because: the current phases are advanced more than -45 degrees due to an induction motor or the like having a small capacity with respect to a phase advance capacitor coupled to an inductive load; or the current phase is delayed more than 0 degrees due to the induction motor or the like having a large capacity. In either case, it is appropriate to determine whether a specification of an apparatus causes a problem or whether a phase of the inductive load is correctively coupled.

Power Control Apparatus Control Flow

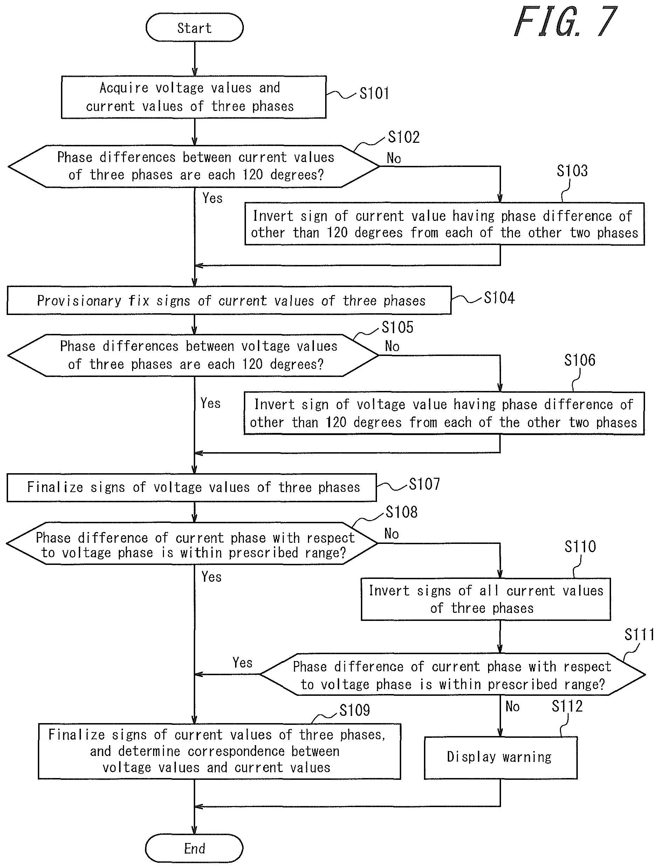

Operation of the power control apparatus 10 will be described with reference to the flowchart illustrated in FIG. 7.

The voltage measurement unit 11 of the power control apparatus 10 acquires the three-phase voltage values U1 to U3, and the current measurement unit 12 acquires the three phase current values CT1 to CT3 (step S101).

The controller 13 of the power control apparatus 10 determines whether the phase differences between each of the three phase current values CT1 to CT3 are each 120 degrees (step S102).

In the case of a "No" determination at step S102, the controller 13 inverts a sign of a current value having a phase difference other than 120 degrees from each of the other two current values (step S103) and then provisionally fixes the signs of CT1 to CT3 (step S104).

In the case of a "Yes" determination at step S102, the controller 13 provisionally fixes the signs of CT1 to CT3 in their current state (step S104).

Subsequently, the controller 13 determines whether the phase differences of the three phase voltage values U1 to U3 are each 120 degrees (step S105).

In the case of a "No" determination at step S105, the controller 13 inverts a sign of a voltage value having a phase difference other than 120 degrees from each of the other two voltage values (step S106) and then finalizes the signs of U1 to U3 in this state (step S107).

In the case of a "Yes" determination at step S105, the controller 13 finalizes the signs of U1 to U3 in their current state (step S107).

Subsequently, the controller 13 determines whether the phase differences of the current phases with respect to the voltage phases are within the prescribed range (step S108).

In the case of a "Yes" determination at step S108, the controller 13 finalizes the signs of CT1 to CT3 in their current state and determines the correspondence between CT1 to CT3 and U1 to U3 (step S109).

In the case of a "No" determination at step S108, the controller 13 inverts the signs of all of CT1 to CT3 (step S110) and then determines whether the phase differences of the current phases with respect to the voltage phases are within the prescribed range (step S111).

In the case of a "Yes" determination at step S111, the controller 13 finalizes the signs of CT1 to CT3 in their current state and determines the correspondence between CT1 to CT3 and the U1 to U3 (step S109).

In the case of a "No" determination at step S111, the controller 13 determines that the correspondence between the current values and the voltage values cannot be determined and causes the display 15 to display a warning indicating to that effect (step S112).

According to the present embodiment, as described above, the controller 13 compares the phase differences between the three-phase current values and performs the current value sign correction operation to invert a sign of a current value of one of the three phases having a phase difference equal to or smaller than the predetermined phase difference from each of the other two phases. In this way, the phases and the directions of the current values acquired for a three-phase AC power source may be autonomously determined. Accordingly, a situation where normal power measurement for a three-phase AC power source is not possible due to an installment error during installation of a current sensor for measuring the current can be avoided.

According to the present embodiment, also, the controller 13 compares the phase differences between the three phase voltage values and performs the voltage value sign correction operation to invert a sign of a voltage value of one of the three phases having a phase difference equal to or smaller than the predetermined phase difference from each of the other two phases. In this way, the phases and the polarities of the voltage values acquired for a three-phase AC power source may be autonomously determined. Accordingly, a situation where normal power measurement for a three-phase AC power source is not possible due to an installment error during installation of the wiring for measuring the voltage can be avoided.

According to the present embodiment, further, when the three phases of the current values subjected to the current value sign correction operation are in the predetermined phase relation with the three phases of the voltage values subjected to the voltage value sign correction operation, the controller 13 performs the operation to determine correspondence between the current values and the voltage values in this state. On the other hand, when the three phases of the current values subjected to the current value sign correction operation are not in the predetermined phase relation with the three phases of the voltage values subjected to the voltage value sign correction operation, the controller 13 inverts the signs of all of the current values subjected to the current value sign correction operation. Subsequently, the controller 13 performs the operation to determine correspondence between the current values and the voltage values. In this way, the correspondence between the current values of the three phases and the voltage values of the three phases for the three-phase AC power source can be determined. Accordingly, the power for the three-phase power source can be correctly calculated.

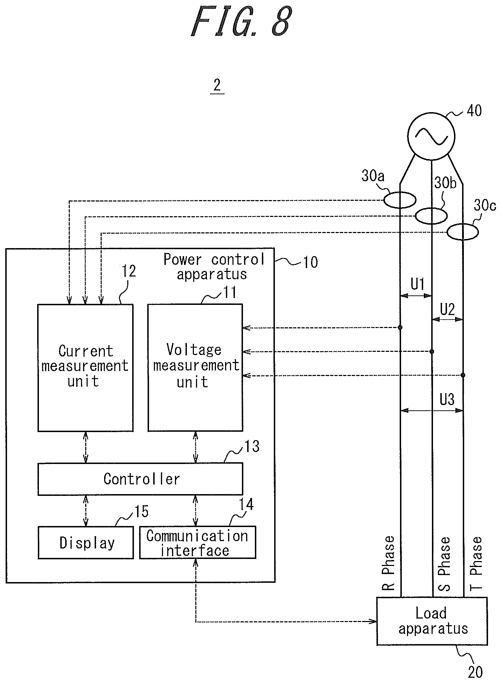

Although the three-phase AC power source of the present embodiment is described as having a three-phase four-wire distribution system by way of example, the disclosure is also applicable to a three-phase AC power source having a three-phase three-wire distribution system as illustrated in FIG. 8. In a power control system 2 illustrated in FIG. 8, the power grid 40 supplies power to the load apparatus 20 through a three-phase three-wire distribution system, and in this case the voltage values U1 to U3 are measured in the manner illustrated in FIG. 8.

Although the disclosure has been described based on the figures and the embodiment, it is to be understood that those who are ordinarily skilled in the art may easily implement various modifications and changes based on the disclosure herein. Therefore, such modifications and changes are included in the scope of the disclosure herein. For example, functions and the like included in each constituent and step may be rearranged without logical inconsistency, so as to combine a plurality of constituents or steps together or to separate them. It is also to be understood that, although the apparatus is mainly described above, a method executed by a processor of the apparatus of the disclosure, a program, and a storage medium storing the program may also implement the disclosure herein and thus are included in the scope of the disclosure.

Many aspects of the disclosure herein may be represented by a series of operations executed by a computer system or other hardware those are capable of executing a program instruction. The computer system or the other hardware include, for example, a general-purpose computer, a PC (personal computer), a special purpose computer, a workstation, PCS (Personal Communications System; a personal mobile communication system), an electronic notepad, a laptop computer, and other programmable data processing apparatuses. Note that in the embodiment of the disclosure the various operations are executed by a dedicated circuit implemented with a program instruction (software) (e.g., discrete logic gates interconnected to perform a specific function), or a logical block, a program module and the like executed by at least one processor. The at least one processor for executing the logical block, the program module and the like includes, for example, at least one microprocessor, CPU (Central Processing Unit), ASIC (Application Specific Integrated Circuit), DSP (Digital Signal Processor), PLD (Programmable Logic Device), FPGA (Field Programmable Gate Array), a controller, a microcontroller, an electronic apparatus, and other apparatuses designed to be capable of executing the functions described herein, and/or a combination thereof. The embodiment presented herein is implemented by, for example, hardware, software, firmware, middleware, a microcode, or any combination thereof.

Also, the machine-readable non-transitory storage medium used herein may be constituted by using a solid state memory or a tangible carrier (medium) readable by the computer such as a magnetic disk and an optical disk. This medium stores an appropriate set of computer instructions such as program modules and a data structure those for making the processor to execute the technique disclosed herein. The computer-readable medium includes an electric connection with at least one wiring, a magnetic disk storage media, other magnetic and optical storage devices such as a CD (Compact Disk), a DVD® (Digital Versatile Disc; DVD is a registered trademark in Japan, other countries, or both), and a Blu-ray disc, a portable computer disk, RAM (Random Access Memory), ROM (Read-Only Memory), a ROM such as an EPROM, an EEPROM, or a flash memory that is rewritable and programmable, other tangible storage media capable of storing information, or any combination thereof. The memory may be provided inside and/or outside the processor/processing unit. Here, the term "memory" means all types of a long-term memory, a short-term memory, a volatile memory, a non-volatile memory, and other memories. A type of the memory, the number of memories, and a type of the medium to store the information are not limited.

REFERENCE SIGNS LIST

| | |
|---|---|
| 1, 2 | power control system |
| 10 | power control apparatus |
| 11 | voltage measurement unit |
| 12 | current measurement unit |
| 13 | controller |
| 14 | communication interface |
| 15 | display |
| 20 | load apparatus |
| 30a, 30b, 30c | current sensor |
| 40 | power grid |

**Claims**

1. A power control apparatus (10) for acquiring three-phase current values from a first current sensor (30a), a second current sensor (30b), and a third current sensor (30c) provided to a three-phase AC power source having a first phase, a second phase and a third phase, the power control apparatus (10) comprising:

   a current measurement unit (12) configured to acquire the three-phase current values of the three-phase AC power source from the first current sensor (30a), the second current sensor (30b), and the third current sensor (30c); and
   a controller (13) configured to compare phase differences between the three-phase current values,
   **characterized in that**
   the controller (13) is further configured to detect an installment error when a current value of one of the three phase current values has a phase difference, from each of the other two phases, equal to or smaller than a predetermined phase difference, and to perform a current value sign correction operation to invert a sign of the current value in response to detecting the installment error.

2. The power control apparatus (10) according to claim 1,
further comprising a voltage measurement unit (11) for acquiring three-phase voltage values of the three-phase AC power source from the first phase, the second phase, and the third phase,
wherein the controller (13) is configured to compare phase differences between the three-phase voltage values and perform a voltage value sign correction operation to invert a sign of a voltage value of one of the three-phase voltage values having a phase difference, from each of the other two phases, equal to or smaller than a predetermined phase difference.

3. The power control apparatus (10) according to claim 2,
wherein the controller (13) is configured to:

when the three-phase current values subjected to the current value sign correction operation are in a predetermined phase relation with the three-phase voltage values subjected to the voltage value sign correction operation, perform an operation to determine correspondence between the three-phase current values and the three-phase voltage values, or
when the three-phase current values subjected to the current value sign correction operation are not in the predetermined phase relation with the three-phase voltage values subjected to the voltage value sign correction operation, invert signs of each of the three-phase current values subjected to the current value sign correction operation, and then perform the operation to determine correspondence between the three-phase current values and the three-phase voltage values.

4. The power control apparatus (10) according to claim 3,
further comprising a communication interface configured to transmit an operation instruction to a load apparatus coupled to the three-phase AC power source,
wherein the controller (13) is configured to perform the current value sign correction operation, the voltage value sign correction operation, and the operation to determine correspondence between the three-phase current values and the three-phase voltage values when the load apparatus is in an operating state.

5. The power control apparatus (10) according to claim 3 or 4,
further comprising a display (15),
wherein the controller (13) is configured to invert the signs of all of the three-phase current values when the three-phase current values subjected to the current value sign correction operation are not in the predetermined phase relation with the three-phase voltage values subjected to the voltage value sign correction operation and then, when the three-phase current values are still not in the predetermined phase relation with the three-phase voltage values subjected to the voltage value sign correction operation, the controller (13) causes the display (15) to display a warning.

6. A control method for a power control apparatus (10) to acquire three-phase current values from a first current sensor (30a), a second current sensor (30b), and a third current sensor (30c) provided to a three-phase AC power source having a first phase, a second phase and a third phase, the control method comprising:

a step of acquiring the three-phase current values of the three-phase AC power source from the first current sensor, the second current sensor and the third current sensor; and
a step of comparing phase differences between the three-phase current values,
**characterized by**
a step of detecting an installment error when a current value of one of the three phase current values has
a phase difference, from each of the other two phases, equal to or smaller than a predetermined phase difference, and
a step of performing a current value sign correction operation to invert a sign of the current value in response to detecting the installment error.

7. The control method according to claim 6, further comprising:

a step of acquiring three-phase voltage values of the three-phase AC power source from the first phase, the second phase, and the third phase; and
a step of comparing phase differences between the three-phase voltage values and performing a voltage value sign correction operation to invert a sign of a voltage value of one of the three phases having a phase difference, from each of the other two phases, equal to or smaller than a predetermined phase difference.

8. The control method according to claim 7, further comprising:

a step of performing, when the three-phase current values subjected to the current value sign correction operation are in a predetermined phase relation with the three-phase voltage values subjected to the voltage value sign correction operation, an operation to determine correspondence between the three-phase current values and the three-phase voltage values; or a step of performing, when the three-phase current values subjected to the current value sign correction operation are not in the predetermined phase relation with the three-phase voltage values subjected to the voltage value sign correction operation, inversion of signs of each of the three-phase current values subjected to the current value sign correction operation, and then performing the operation to determine correspondence between the three-phase current values and the three-phase voltage values.

**Patentansprüche**

1. Stromsteuervorrichtung (10) zum Erwerb von Dreiphasenstromwerten von einem ersten Stromsensor (30a), einem zweiten Stromsensor (30b) und einem dritten Stromsensor (30c), bereitgestellt für eine dreiphasige Wechselstromquelle mit einer ersten Phase, einer zweiten Phase und einer dritten Phase, wobei die Leistungssteuervorrichtung (10) Folgendes umfasst:

   eine Strommesseinheit (12), die konfiguriert ist, um die Dreiphasenstromwerte der dreiphasige Wechselstromquelle von dem ersten Stromsensor (30a), dem zweiten Stromsensor (30b) und dem dritten Stromsensor (30c) zu erwerben; und
   eine Steuerung (13), die konfiguriert ist, um Phasendifferenzen zwischen den Dreiphasenstromwerten zu vergleichen,
   **gekennzeichnet dadurch, dass**
   die Steuerung (13) ferner konfiguriert ist, um einen Installationsfehler zu erfassen, wenn ein Stromwert von einem der drei Phasenstromwerte Phasendifferenz zu jedem der anderen zwei Phasen gleich wie oder kleiner als eine vorbestimmte Phasendifferenz aufweist, und um einen Stromwertvorzeichenkorrekturvorgang durchzuführen, um ein Vorzeichen des Stromwerts als Reaktion auf das Erfassen des Installationsfehlers umzukehren.

2. Stromsteuervorrichtung (10) nach Anspruch 1, ferner umfassend eine Spannungsmesseinheit (11) zum Erwerb von Dreiphasenspannungswerten der dreiphasigen Wechselstromquelle von der ersten Phase, der zweiten Phase und der dritten Phase, wobei die Steuerung (13) konfiguriert ist, um Phasendifferenzen zwischen den Dreiphasenspannungswerten zu vergleichen, und um einen Spannungswertvorzeichenkorrekturvorgang durchzuführen, um ein Vorzeichen eines Spannungswerts von einem der Dreiphasenspannungswerte umzukehren, der eine Phasendifferenz zu jedem der anderen zwei Phasen gleich wie oder kleiner als eine vorbestimmte Phasendifferenz aufweist.

3. Stromsteuervorrichtung (10) nach Anspruch 2, wobei die Steuerung (13) zu Folgendem konfiguriert ist:

   wenn die Dreiphasenstromwerte, die dem Stromwertvorzeichenkorrekturvorgang ausgesetzt sind, in einer vorbestimmten Phasenbeziehung mit den Dreiphasenspannungswerten, die dem Spannungswertvorzeichenkorrekturvorgang ausgesetzt sind, stehen, Durchführen eines Vorgangs, um Übereinstimmung zwischen den Dreiphasenstromwerten und den Dreiphasenspannungswerten zu bestimmen, oder
   wenn die Dreiphasenstromwerte, die dem Stromwertvorzeichenkorrekturvorgang ausgesetzt sind, nicht in der vorbestimmten Phasenbeziehung mit den Dreiphasenspannungswerten, die dem Spannungswertvorzeichenkorrekturvorgang ausgesetzt sind, stehen, Umkehren von Vorzeichen von jedem der Dreiphasenstromwerten, die dem Stromwertvorzeichenkorrekturvorgang ausgesetzt sind, und dann Durchführen des Vorgangs, um Übereinstimmung zwischen den Dreiphasenstromwerten und den Dreiphasenspannungswerten zu bestimmen.

4. Stromsteuervorrichtung (10) nach Anspruch 3, ferner umfassend eine Kommunikationsschnittstelle, die konfiguriert ist, um eine Vorgangsanweisung an eine Lastvorrichtung zu übertragen, die an die dreiphasige Wechselstromquelle gekoppelt ist, wobei die Steuerung (13) konfiguriert ist, um den Stromwertvorzeichenkorrekturvorgang, den Spannungswertvorzeichenkorrekturvorgang und den Vorgang, um Übereinstimmung zwischen den Dreiphasenstromwerten und den Dreiphasenspannungswerten zu bestimmen, durchzuführen, wenn die Lastvorrichtung in einem Betriebszustand ist.

5. Stromsteuervorrichtung (10) nach Anspruch 3 oder 4, ferner umfassend eine Anzeige (15), wobei die Steuerung (13) konfiguriert ist, um die Vorzeichen aller Dreiphasenstromwerte umzukehren, wenn die Dreiphasenstromwerte, die dem Stromwertvorzeichenkorrekturvorgang ausgesetzt sind, nicht in der vorbestimmten Phasenbeziehung mit den Dreiphasenspannungswerten stehen, die dem Spannungswertvorzeichenkorrekturvorgang ausgesetzt sind, und dann, wenn die Dreiphasenstromwerte immer noch nicht in der vorbestimmten Phasenbeziehung mit den Dreiphasenspannungswerten stehen, die dem Spannungswertvorzeichenkorrekturvorgang ausgesetzt sind, die Steuerung (13) verursacht, dass die Anzeige (15) eine Warnung anzeigt.

6. Steuerverfahren für eine Stromsteuervorrichtung (10), um Dreiphasenstromwerte von einem ersten Stromsensor (30a), einem zweiten Stromsensor (30b) und einem dritten Stromsensor (30c) zu erwerben, bereitgestellt für eine dreiphasige Wechselstromquelle mit einer ersten Phase, einer zweiten Phase und einer dritten Phase, wobei das Steuerverfahren Folgendes umfasst:

    einen Schritt des Erwerbens der Dreiphasenstromwerte der dreiphasigen Wechselstromquelle von dem ersten Stromsensor, dem zweiten Stromsensor und dem dritten Stromsensor; und

    einen Schritt des Vergleichens von Phasendifferenzen zwischen den Dreiphasenstromwerten,

    **gekennzeichnet durch**

    einen Schritt des Erfassens eines Installationsfehlers, wenn ein Stromwert von einem der drei Phasenstromwerte eine Phasendifferenz zu jedem der anderen zwei Phasen gleich wie oder kleiner als eine vorbestimmte Phasendifferenz aufweist, und

    einen Schritt des Durchführens eines Stromwertvorzeichenkorrekturvorgangs, um ein Vorzeichen des Stromwerts als Reaktion auf das Erfassen des Installationsfehlers umzukehren.

7. Steuerverfahren nach Anspruch 6, ferner umfassend:

    einen Schritt des Erwerbens von Dreiphasenspannungswerten der dreiphasigen Wechselstromquelle von der ersten Phase, der zweiten Phase und der dritten Phase; und

    einen Schritt des Vergleichens von Phasendifferenzen zwischen den Dreiphasenspannungswerten und des Durchführens eines Spannungswertvorzeichenkorrekturvorgangs, um ein Vorzeichen eines Spannungswerts von einem der drei Phasen umzukehren, die eine Phasendifferenz zu jedem der anderen zwei Phasen gleich wie oder kleiner als eine vorbestimmte Phasendifferenz aufweist.

8. Steuerverfahren nach Anspruch 7, ferner umfassend:

    einen Schritt des Durchführens, wenn die Dreiphasenstromwerte, die dem Stromwertvorzeichenkorrekturvorgang ausgesetzt sind, in einer vorbestimmten Phasenbeziehung mit den Dreiphasenspannungswerten, die dem Spannungswertvorzeichenkorrekturvorgang ausgesetzt sind, stehen, eines Vorgangs, um Übereinstimmung zwischen den Dreiphasenstromwerten und den Dreiphasenspannungswerten zu bestimmen; oder

einen Schritt des Durchführens, wenn die Dreiphasenstromwerte, die dem Stromwertvorzeichenkorrekturvorgang ausgesetzt sind, nicht in der vorbestimmten Phasenbeziehung mit den Dreiphasenspannungswerten, die dem Spannungswertvorzeichenkorrekturvorgang ausgesetzt sind, stehen, einer Umkehrung von Vorzeichen von jedem der Dreiphasenstromwerten, die dem Stromwertvorzeichenkorrekturvorgang ausgesetzt sind, und dann des Durchführens des Vorgangs, um Übereinstimmung zwischen den Dreiphasenstromwerten und den Dreiphasenspannungswerten zu bestimmen.

**Revendications**

1. Appareil de commande de puissance (10) destiné à acquérir des valeurs de courant triphasé auprès d'un premier capteur de courant (30a), d'un second capteur de courant (30b) et d'un troisième capteur de courant (30c) fourni à une source d'alimentation en courant alternatif triphasé ayant une première phase, une deuxième phase et une troisième phase, l'appareil de commande de puissance (10) comprenant:

    une unité de mesure de courant (12) configurée pour acquérir les valeurs de courant triphasé de la source d'alimentation en courant alternatif triphasé provenant du premier capteur de courant (30a), du second capteur de courant (30b) et du troisième capteur de courant (30c) ; et

    un contrôleur (13) configuré pour comparer les différences de phase entre les valeurs de courant triphasé,

    **caractérisé en ce que**

    le contrôleur (13) est en outre configuré pour détecter une erreur d'installation lorsqu'une valeur actuelle de l'une des trois valeurs de courant de phase a une différence de phase, à partir de chacune des deux autres phases, égale ou inférieure à une différence de phase prédéterminée, et pour effectuer une opération de correction de signe de valeur actuelle pour inverser un signe de la valeur actuelle en réponse à la détection de l'erreur d'installation.

2. Appareil de commande de puissance (10) selon la revendication 1, comprenant en outre une unité de mesure de tension (11) pour acquérir des valeurs de tension triphasée de la source d'alimentation en courant alternatif triphasé à partir de la première phase, de la deuxième phase et de la troisième phase,

dans lequel le contrôleur (13) est configuré pour comparer les différences de phase entre les valeurs de tension triphasée et effectuer une opération de correction de signe de valeur de tension afin d'inverser le signe d'une valeur de tension de l'une des valeurs de tension triphasée ayant une différence de phase, de chacune des deux autres phases, égale ou inférieure à une différence de phase prédéterminée.

3. Appareil de commande de puissance (10) selon la revendication 2,

dans lequel le contrôleur (13) est configuré pour :

lorsque les valeurs de courant triphasé soumises à l'opération de correction de signe de valeur de courant sont dans une relation de phase prédéterminée avec les valeurs de tension triphasée soumises à l'opération de correction de signe de valeur de tension, effectuer une opération pour déterminer la correspondance entre les valeurs de courant triphasé et les valeurs de tension triphasée, ou

lorsque les valeurs de courant triphasé soumises à l'opération de correction de signe de valeur de courant ne sont pas dans la relation de phase prédéterminée avec la tension triphasée soumise à l'opération de correction de signe de valeur de tension, inverser les signes de chacune des valeurs de courant triphasé soumises à l'opération de correction de signe de valeur actuelle, puis effectuer l'opération pour déterminer la correspondance entre les valeurs de courant triphasé et les valeurs de tension triphasée.

4. Appareil de commande de puissance (10) selon la revendication 3,

comprenant en outre une interface de communication configurée pour transmettre une instruction d'opération à un appareil de charge couplé à la source d'alimentation en courant alternatif triphasé,

dans lequel le contrôleur (13) est configuré pour effectuer l'opération de correction de signe de valeur de courant, l'opération de correction de signe de valeur de tension et l'opération pour déterminer une correspondance entre les valeurs de courant triphasé et les valeurs de tension triphasée lorsque l'appareil de charge est en un état de fonctionnement.

5. Appareil de commande de puissance (10) selon la revendication 3 ou 4,

comprenant en outre un affichage (15),

dans lequel le contrôleur (13) est configuré pour inverser les signes des valeurs de courant triphasé lorsque les valeurs de courant triphasé soumises à l'opération de correction de signe de valeur de courant ne sont pas en relation de phase prédéterminée avec les valeurs de tension triphasée soumises à l'opération de correction de signe de valeur de tension, puis, lorsque les valeurs de courant triphasé sont toujours pas dans la relation de phase prédéterminée avec les valeurs de tension triphasée soumises à l'opération de correction de signe de valeur de tension, le contrôleur (13) fait afficher un avertissement à l'écran (15).

6. Procédé de commande d'un appareil de commande de puissance (10) pour acquérir des valeurs de courant triphasé à partir d'un premier capteur de courant (30a), d'un second capteur de courant (30b) et d'un troisième capteur de courant (30c) fourni à une source d'alimentation en courant alternatif triphasé ayant une première phase, une deuxième phase et une troisième phase, le procédé de commande comprenant :

une étape d'acquisition des valeurs de courant triphasé de la source d'alimentation en courant alternatif triphasé auprès du premier capteur de courant, du second capteur de courant et du troisième capteur de courant ; et

une étape de comparaison de différences de phase entre les valeurs de courant triphasé, **caractérisé par**

une étape de détection d'une erreur d'installation lorsqu'une valeur actuelle de l'une des trois valeurs de courant de phase présente une différence de phase parmi chacune des deux autres phases égale ou inférieure à une différence de phase prédéterminée, et

une étape d'exécution d'une opération de correction de signe de valeur actuelle pour inverser un signe de la valeur actuelle en réponse à la détection de l'erreur d'installation.

7. Procédé de commande selon la revendication 6, comprenant en outre :

une étape d'acquisition des valeurs de tension triphasée de la source d'alimentation en courant alternatif triphasé à partir de la première phase, de la deuxième phase et de la troisième phase; et

une étape consistant à comparer les différences de phase entre les valeurs de tension triphasée et à effectuer une opération de correction de signe de valeur de tension pour inverser le signe d'une valeur de tension de l'une des trois phases présentant une différence de phase par rapport à chacune des deux autres phases, égale à ou inférieure à une différence de phase prédéterminée.

8. Procédé de commande selon la revendication 7, comprenant en outre :

une étape consistant à effectuer, lorsque les valeurs de courant triphasé soumises à l'opération de correction de signe de valeur actuelle sont dans une relation de phase prédéterminée avec les valeurs de tension triphasée soumises à l'opération de correction de signe de valeur de tension, une opération permettant de déterminer la correspondance entre les valeurs de courant triphasé et les valeurs de tension triphasée ; ou

une étape consistant à effectuer, lorsque les valeurs de courant triphasé soumises à l'opération de correction de signe de valeur actuelle ne sont pas dans la relation de phase prédéterminée avec les valeurs de tension triphasé soumises à l'opération de correction de signe de valeur de tension, l'inversion des signes de chacun des valeurs de courant triphasé soumises à l'opération de correction de signe de valeur en cours, puis en effectuant l'opération pour déterminer la correspondance entre les valeurs de courant triphasé et les valeurs de tension triphasée.

# FIG. 1

<u>1</u>

## FIG. 2A

## FIG. 2B

*FIG. 3A*

*FIG. 3B*

# FIG. 4

## FIG. 5A

## FIG. 5B

# *FIG. 6*

CT1
(After inversion)

U1

CT2

−45°

CT3

CT3
(After inversion)

U3

U2

CT2
(After inversion)

CT1

*FIG. 7*

```
                    ( Start )
                        │
                        ▼
        ┌──────────────────────────────┐
        │   Acquire voltage values and │  ~S101
        │   current values of three phases │
        └──────────────────────────────┘
                        │
                        ▼
         ┌────────────────────────────┐   ~S102
        ╱  Phase differences between current values ╲  No
        ╲  of three phases are each 120 degrees?    ╱────────────┐
         └────────────────────────────┘                         │  S103
                        │ Yes                                    ▼
                        │            ┌──────────────────────────────────────────┐
                        │            │ Invert sign of current value having phase difference of │
                        │            │ other than 120 degrees from each of the other two phases │
                        │            └──────────────────────────────────────────┘
                        │◄───────────────────────┘
                        ▼
        ┌──────────────────────────────────────────┐
        │ Provisionary fix signs of current values of three phases │  ~S104
        └──────────────────────────────────────────┘
                        │
                        ▼
         ┌────────────────────────────┐   ~S105
        ╱  Phase differences between voltage values ╲  No
        ╲  of three phases are each 120 degrees?     ╱────────────┐
         └────────────────────────────┘                          │  S106
                        │ Yes                                     ▼
                        │            ┌──────────────────────────────────────────┐
                        │            │ Invert sign of voltage value having phase difference of │
                        │            │ other than 120 degrees from each of the other two phases │
                        │            └──────────────────────────────────────────┘
                        │◄───────────────────────┘
                        ▼
        ┌──────────────────────────────────────────┐
        │ Finalize signs of voltage values of three phases │  ~S107
        └──────────────────────────────────────────┘
                        │
                        ▼
         ┌────────────────────────────┐   ~S108
        ╱  Phase difference of current phase with respect ╲  No
        ╲  to voltage phase is within prescribed range?    ╱────────────┐
         └────────────────────────────┘                                 │  S110
                        │ Yes                                            ▼
                        │                          ┌──────────────────────────┐
                        │                          │ Invert signs of all current values │
                        │                          │       of three phases            │
                        │                          └──────────────────────────┘
                        │                                          │  S111
                        │              Yes  ┌────────────────────────────┐
                        │◄─────────────────╱ Phase difference of current phase with respect ╲
                        │                  ╲ to voltage phase is within prescribed range?    ╱
                        │                   └────────────────────────────┘
                        ▼                                  │ No   S112
        ┌────────────────────────────┐  ~S109             ▼
        │ Finalize signs of current values of three phases, │    ┌──────────────────┐
        │    and determine correspondence between           │    │ Display warning  │
        │       voltage values and current values           │    └──────────────────┘
        └────────────────────────────┘                              │
                        │◄──────────────────────────────────────────┘
                        ▼
                    ( End )
```

*FIG. 8*

2

## FIG. 9

## FIG. 10

**EP 3 252 907 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004297959 A
- JP 2002168883 A
- EP 1457785 A2
- WO 2014125590 A1